# EUROPÄISCHE PATENTSCHRIFT

(11) **EP 0 406 919 B1**
(45) Veröffentlichungstag und Bekanntmachung des Hinweises auf die Patenterteilung: **14.10.1998**
(21) Anmeldenummer: 90116283.4
(22) Anmeldetag: 08.07.1987
(51) Int. Cl.: G01R 1/073

(54) **Vorrichtung zum elektronischen Prüfen von Leiterplatten mit Kontaktpunkten in extrem feinem Raster (1/20 bis 1/10 Zoll)**
Arrangement for electronically testing printed circuits with extremely fine contact-point screen
Dispositif pour contrôler électroniquement des circuits imprimés comportant des pointes de contact à module extrêmement fin

(30) Priorität: 08.09.1986 DE 3630548
(43) Veröffentlichungstag der Anmeldung: 09.01.1991
(62) Teilanmeldung aus: 87109884.4
(73) Patentinhaber: MANIA Elektronik Automatisation Entwicklung und Gerätebau GmbH, D-61276 Weilrod (DE)
(72) Erfinder: Driller, Hubert, Dipl.-Phys., D-6384 Schmitten 3 (DE); Mang, Paul, D-6384 Schmitten 3 (DE)
(74) Vertreter: Ruschke, Hans Edvard, Dipl.-Ing.

(56) Entgegenhaltungen:
- DE-C- 3 340 180
- DE-U- 8 534 841

## Beschreibung

Die Erfindung betrifft eine Vorrichtung zum elektronischen Prüfen von Leiterplatten nach dem Oberbegriff des Anspruches 1.

Wegen des zunehmenden Dranges zur Miniaturisierung aber auch wegen der damit einhergehenden kostengünstigeren Fertigung gehen die Hersteller in aller Welt zunehmend dazu über, elektronische Baugruppen mit Hilfe von Lei terplatten aufzubauen. die Kontaktpunkte oder Kontakffelder im Rastermaß 1/20 Zoll und bis zu 1/100 Zoll haben. Hierbei bedient man sich weitgehend der sogenannten SMD-Technik (surface mounted devices), bei der die Anschlußdrähte oder -fahnen der einzelnen elektronischen Komponenten nicht mehr mit gegebenenfalls durchkontaktierten Bohrungen von mehrlagigen Leiterplatten, sondern mit Anschlußzonen (pads) verbunden werden.

Da sich die Erkenntnis durchgesetzt hat, daß unbestückte Leiterplatten (bare boards) vor der Bestückung mit elektronischen Bauteilen auf ihre Funktionstüchtigkeit geprüft werden müssen um sicherzustellen. daß nicht mehr und nicht weniger als alle gewünschten Verbindungen vorhanden sind, ergibt sich für die Hersteller von Leiterplattenprüfgeräten die Notwendigkeit, Geräte anzubieten, mit denen Leiterplatten nahezu in beliebiger Größe und Konfiguration im 1/20 Zoll-Kontaktpunkt-Raster und deutlich darunter problemlos geprüft werden können.

In der DE-PS 33 40 180 wird eine Kontakffeldanordnung für rechnergesteuerte Leiterplatten-Prüfgeräte im 1/10 Zoll Kontaktpunkt-Raster beschrieben. Das Kontaktfeld ist hierbei in Kontakffeldabschnitte unterteilt die jeweils für sich über längere Stützstreben gegen eine Grundplatte lösbar abgestützt sind. Der somit geschaffene Raum wird zur Unterbringung der diesen Kontakffeld abschnitten zugehörigen Elektronikbauteile ausgenützt, die über eine Steckverbindung mit der zweidimensionalen Ansteuerschaltung auf der Grundplatte verbunden sind. Diese "Kontakfleldmoduln" genannten Bauteile sind untereinander identisch und in Bezug auf die jeweiligen Plätze auf der Grundplatte austauschbar. Durch dieses Konzept wird ein Leiterplattenprüfgerät geschaffen, das trotz eines in der Grundkonzeption sehr groß angelegten Kontakffeldes (beispielsweise 256 Kontakte jeweils in X-und Y-Richtung) bereits mit wenig Elektronik betreibbar und problemlos nachrüstbar ist.

Dieses Konzept auch bei einem Kontaktpunkt-raster 1/20 Zoll und darunter zu realisieren ist das grundlegende Bestreben der vorliegenden Erfindung. Es gelingt zwar, mit einem sogenannten "Reduktionsadapter" (DE-PS 33 40 179) die bis zu 64.000 Kontaktpunkte des 1/10-Ausgangsrasters dieser Kontaktfeldanordnung für alle ca. 64.000 Kontaktpunkte in X- und Y-Richtung des Kontakffeldes auf ein Raster von 1/20 Zoll zu reduzieren, doch nur um den Preis einer Verringerung der höchstzulässigen Leiterplattenabmessungen um 50 % in beiden Richtungen.

Bei der somit erforderlichen Verwirklichung des Prinzips des Leiterplattenprüfgerätes der DE-PS 33 40 180 im Kontaktpunktraster 1/20 Zoll (gleich 1,27 mm) stößt man zumindest scheinbar auf Grenzen der Miniaturisierung, wie sie im folgenden dargestellt werden sollen. Hierbei ist zu beachten, daß sich diese Grenzen auch von der Kostenseite her auftun. Bei einem Leiterplattenprüfgerät mit einer Kontaktfeldanordnung gemäß der DE-PS 33 40 180 erfolgt die mechanische Kontaktierung der Kontaktpunkte der zu prüfenden Leiterplatte und der Kontaktpunkte des Kontakffeldrasters des Leiterplattenprüfgerätes durch Prüfnadeln, die jeweils eine in Längsrichtung federnd ausgebildete Kontaktspitze haben. Diese federnden Prüfstifte sind bei dem herkömmlichen Kontaktpunktabstand von 2,54 mm noch relativ einfach und preiswert herstellbar, doch ergeben sich zunehmend Probleme, wenn ein Kontaktpunktabstand von 1.27 mm vorgeschrieben wird, d.h. wenn diesem Prüfstift allenfalls ein Durchmesser von etwa 0,8 mm zugestanden werden kann. Derartig dünne Prüfstifte knicken beispielsweise bei geringsten Querkräften aus und werden damit unbrauchbar. Außerdem lassen sich derartige Prüfstifte mit einer federnden Kontaktspitze wegen der notwendigen mechanischen Komplexität nur zu Gestehungskosten fertigen, die angesichts der maximal benötigten Zahl solcher Prüfstifte zu einem erheblichen Problem werden können. Wo bei gleichen äußeren Abmessungen der Kontaktfeldanordnung beim bisherigen Kontaktpunktraster 1/10 Zoll = 2,54 mm etwa 64.000 Kontaktpunkte maximal vorhanden und mithin entsprechend viele Prüfstifte notwendig waren, werden bei einem Kontaktpunktabstand von 1,27 mm bis zu 256.000 Kontaktpunkte innerhalb der gleichen äußeren Kontaktfeldabmessungen möglich. Es liegt auf der Hand, daß bei der eventuell benötigten sehr hohen Anzahl von Prüfstiften die Kosten für einen einzelnen Prüfstift sehr erheblich und vielleicht kaufentscheidend ins Gewicht fallen können. Es ist daher wesentlich, das Prinzip der Kontaktierung der einzelnen "Kontaktteldmoduln" gemäß der DE-PS 33 40 180 bei einer Übertragung dieses Prinzips auf extrem feine Kontaktfeldraster so einfach und kostengünstig wie möglich auszugestalten.

Im DE-GM 85 34 841.4 vom 20.2.1986 wirc vorgeschlagen, in Längrichtung starre konturlose Prüfstifte ohne federnde Kontaktspitzen insbesondere dann zu benutzen, wenn die Leiterplatten bereichsweise Anschlußdichten aufweisen, die größer sind als die mittlere Anschlußdichte im Grundraster des Kontaktfeldes des Leiterplatfenprüfgerätes welches ein Grundraster von 1/10 Zoll hat. Da solche starre konturlose Kontaktstifte sehr einfach und mit einem recht geringen Durchmesser hergestellt werden können, d.h. also daß Kontaktdichten geprüft werden können, die zumindest bereichsweise kleiner sind als das Grundraster des Leiterplattenprüfgerätes. ohne daß sich eine ernsthafte Gefahr von Kurzschlüssen zwischen den einzelnen Prüfstiften ergibt, und da solche konturlose starre Prüfstifte sehr preiswert hergestellt werden können, scheint es sich zunächst anzubieten, derartige starre Prüfstifte auch bei der Leiterplattenprüfung/Kontaktierung im 1/20 Zoll Raster einzusetzen. Allerdings muß hierbei beachtet werden, daß bei dieser bekannten Lösung gemäß DE-GM 85 34 841.4 (Flexadapter) ein sogenanntes "aktives Grundraster" für den Längenausgleich zwischen allen eingesetzten starren Prüfstiften und somit für die zuverlässige Kontaktgabe aller dieser Prüfstifte mit den Prüflingen wie Leiterplatten, Keramik-Verbindungsträgern oder flexiblen Leiterplatten zu sorgen hat. Ein solcher Längenausgleich ist notwendig, um ein mögliches Ausbiegen der starren Feststifte und eine variable Dicke der gedruckten Leiterplatten zu kompensieren und um einen guten Kontaktdruck sicherzustellen. Ein derartiges aktives Grundraster entsteht dadurch, daß der federnde Teil der Kontaktstifte in das Grundraster des Leiterplattenprüfgerätes verlegt wird, was in der Form geschieht. daß kurze kleine Prüfstifte in Form von Hülsen vorgesehen werden, von denen das eine Ende eine Kontaktspitze und das andere Ende einen Innenkonus aufweist, der von einer in der Hülse angeordneten Feder abgestützt wird und zur Aufnahme des einen Endes des starren Prüfstiftes dient. In dem aktiven Grundraster gemäß DE-GM 85 34 841 sind also viele kurze "Prüfstifte mit Innenkonus" entsprechend der Anzahl der vorgesehenen Kontaktpunkte in einem geeigneten Gehäuse oberhalb des eigentlichen Grundrasters des Leiterplattenprüfgerätes vorgesehen. Das grundlegende Problem der relativ hohen Herstellungskosten derartiger "Prüfstifte mit Innenkonus" ist damit also nicht beseitigt - ebenso nicht, daß solche hülsenförmige Prüfstifte mit einer darin angeordneten Druckfeder sehr schwierig - wenn überhaupt - auf Durchmesser in der Größenordnung von 0,8 mm reduziert werden können, wenn bei derart dünnen und somit schwachen Federn ein noch hinreichender Kontaktdruck zugelassen werden soll, zumal die Wandstärke der Hülse aus Gründen der Materialfestigkeit nicht unter 0,2 mm gesenkt werden kann. Es ergäben sich also letztlich auch erhebliche Probleme bei der Realisierung eines derart dicht gepackten "aktiven Grundrasters" für ein Kontaktpunktraster 1/20 Zoll.

Es ist daher die der vorliegenden Erfindung zugrundeliegende Aufgabe, die Art der Kontaktierung der Kontakte einer zu prüfenden Leiterplatte mit dem Kontaktpunktraster des LP-Prüfgerätes dahingehend zu verbessern, daß sich auch bei einem extrem feinen Kontaktpunktraster von 1/20 Zoll (1,27 mm) oder deutlich darunter weder von der Kostenseite noch von der Festigkeitsseite her Probleme wie oben dargestellt ergeben.

Diese Aufgabe wird erfindungsgemäß durch die Merkmale des Anspruches 1 gelost. Indem die Druckfedern selbst zur Aufnahme der starren Prüfstifte vorgesehen und entsprechend ausgestaltet werden, gelingt es trotz der erforderlichen Miniaturisierung, ein funktionierendes und zu erträglichen Kosten herstellbares Kontaktfeldraster vorzusehen.

Eine Herstellung des Federkontaktfeldkörpers aus Keramik oder Kunststoff ist insofern besonders vorteilhaft, als dabei Herstellungstechniken verwendet werden können, die eine besondere Maßhaltigkeit gestatten. Auch wird die Herstellung des Federkontaktfeldkorpers dadurch besonders erleichtert, daß er aus kleineren aneinander anreihbaren oder zusammenfugbaren Abschnitten aufgebaut wird.

Um den pro Druckfeder zur Verfügung stehenden Anteil des gesamten Anpreßdruckes möglichst wirkungsvoll zur Erzeugung eines sicheren Kontaktes zur Wirkung kommen zu lassen, kann es besonders vorteilhaft sein, ein oder beide Enden der Druckfedern so zu wickeln, daß eine stift- oder kegelähnliche Gestalt dort vorgesehen wird.

Weiterhin kann es von Vorteil sein, ein oder beide Enden der Druckfedern so zu wickeln, daß ein Innenkonus zur direkten Aufnahme eines Prüf- oder Kontaktstiftes entsteht. Dadurch haben diese Stifte dann einen sicheren Halt unmittelbar auf der Druckfeder.

Um eine besonders gute Führung der Druckfedern in ihren Bohrungen zu erreichen, können sie in ihren Endbereichen aneinanderliegende Windungen maximalen Durchmessers aufweisen. Zur weiteren Verbesserung der mechanischen Stabilität der Druckfedern können sämtliche aneinanderliegenden Windungen der Druckfedern mechanisch miteinander verbunden werden, was etwa durch galvanische Abscheidung eines Metalles auf den meist aus Federstahl hergestellten Druckfedern geschieht. Dadurch werden dann die aneinanderliegenden Windungen der Druckfeder "zusammenwachsen". Ein Überziehen der Endabschnitte der Druckfedern mit einem speziellen Kontaktwerkstoff - eventuell ebenfalls durch galvanische Abscheidung - kann zur erheblichen Verringerung des Kontaktwiderstandes beitragen.

Insbesondere wenn der die Druckfedern in Bohrungen aufnehmende bzw. führende Federkontaktfeldkörper aus rasterförmig zusammenfügbaren kleineren Segmenten aufgebaut ist, hat es sich als besonders vorteilhaft erwiesen, diese auf ein Tragteil aufzubringen, das als nagelbrettartiger Stecker ausgebildet ist und zur Kraftableitung des aufgebrachten Druckes dient und entsprechend im Leiterplattenprüfgerät abgestützt ist.

Wenn dieser Stecker im Verhältnis zu den rasterförmig zusammenfügbaren Segmenten des Federkontaktfeldkörpers relativ groß ist, kann er für einen guten Zusammenhalt der einzelnen Segmente untereinander sorgen.

Ein Ausführungsbeispiel der vorliegenden Erfindung wird unter Bezugnahme auf die beigefügten Zeichnungen näher beschrieben. Darin zeigt:
Fig. 1 eine Übersicht über den grundsätzlichen Aufbau eines allerdings nicht vollständig dargestellten - Leiterplatfenprüfgerätes, das nach der vorliegenden Erfindung aufgebaut ist;
Fig. 2 in Seiten- bzw. Draufsicht eine sogenannte Treiberplatte mit dem am oberen Ende angeordneten Nagelbrettstecker, der auf Tragschienen abgestützt ist;
Fig. 3 eine ausschnittsweise Teilvergrößerung der erfindungsgemäßen Kontaktierung zwischen der Treiberplatte (der Prüfelektronik) und den starren Prüfstiften; und
Fig. 4a, b, c verschiedene Alternativen der Ausgestaltung der Druckfedern im Federkontaktfeldkörper.

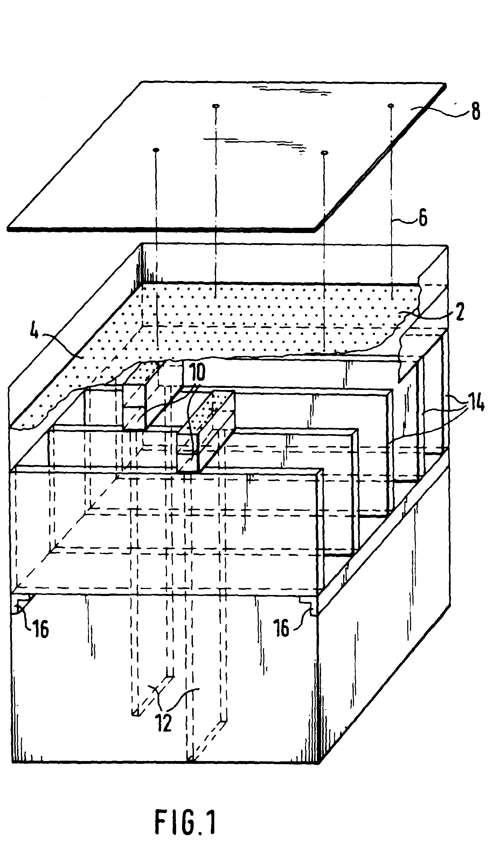

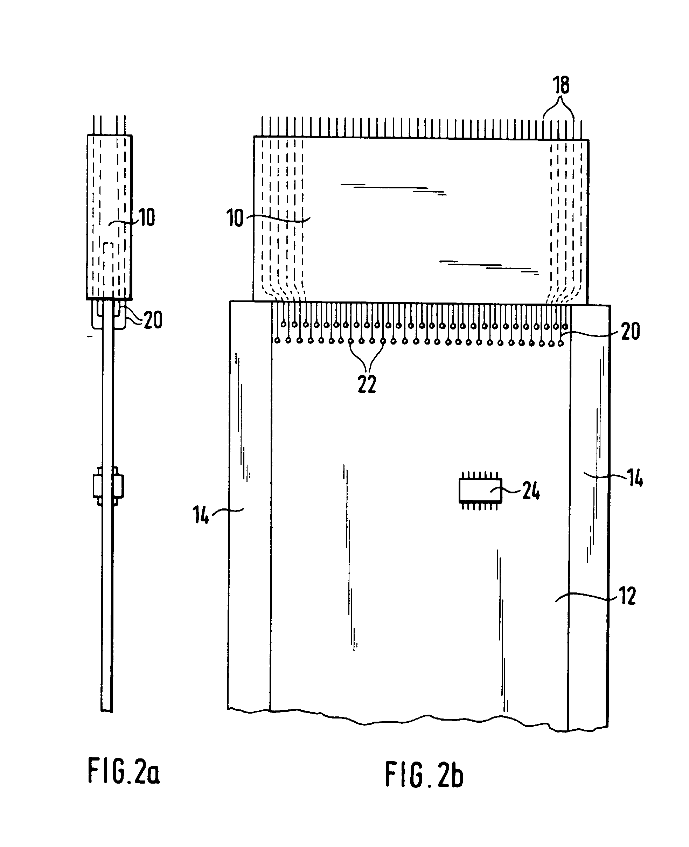

In Fig. 1 ist in prinzipieller Darstellung die Anordnung und Abstützung der einzelnen Bauteile dargestellt, die zusammen das Kontakffeld 2 mit den einzelnen, beispielsweise bis zu ca. 265.000 Kontaktpunkten 4 ausbilden, die über Prüfstifte 6 mit dem/der zu prüfenden Verbindungsträger/Leiterplatte 8 verbindbar sind. Jeweils 4x32 Kontaktpunkte 4 sind einem nagelbrettartigen Kontaktfeldstecker 10 zugeordnet, der am oberen Ende einer sogenannten Treiberplatte 12 sitzt, die die Elektronikbauteile trägt, die zur elektronischen Prüfung der 4x32 = 129 Kontaktpunkte eines Kontaktfeldsteckers 10 beitragen. Am unteren Ende dieser Treiberplatte 12 sind nicht dargestellte Kontaktstecker vorgesehen, die jede der bis zu 2.000 Treiberplatten 12 (Kontaktfeldmoduln) mit einer elektronischen Ansteuerungs- und Meßvorrichtung verbinden, die im unteren Teil der Prüfvorrichtung angeordnet (nicht dargestellt) ist und auf die hier nicht näher eingegangen wird. Wie aus Fig. 2 ersichtlich ist, liegt jeder nagelbrettartige Kontaktfeldstecker 10 an seinen beiden stirnseitigen Enden an Tragteilen 14 auf, die von hochkant angeordneten Platten ausgebildet werden, die den sehr erheblichen Kontaktdruck auf das Gestell 16 des Leiterplattenprüfgerätes ableiten: Da beim Prüfen von Leiterplatten 8 zur Erzeugung eines zuverlässigen Kontaktes ein Kontaktdruck von ca. 125 p pro Kontakt 4 erzeugt werden muß, ergibt sich bei den genannten maximal 256.000 Kontakten ein insgesamt aufzunehmender Druck in Höhe von ca. 32 t, der über diese Tragteile 14 abgeleitet werden muß.

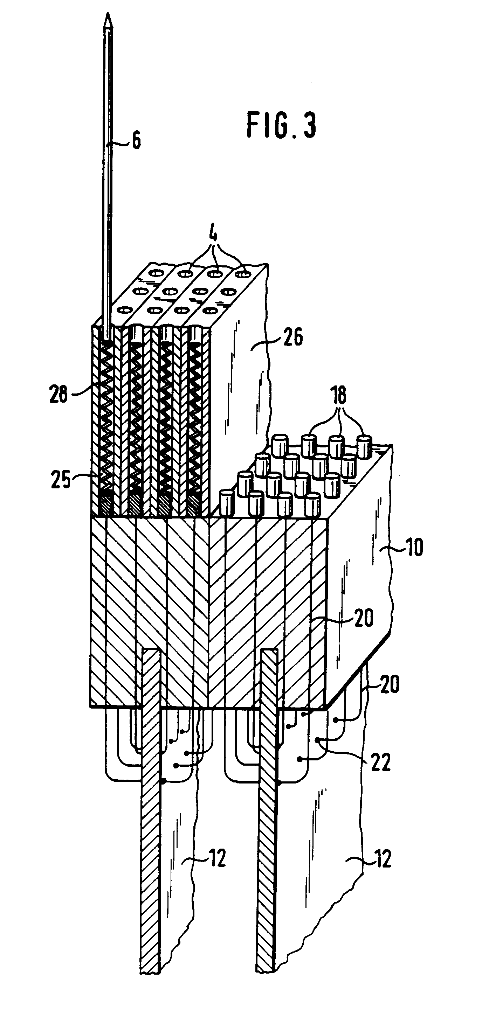

Der aus einem elektrisch nicht leitenden Werkstoff wie Kunststoff oder Keramik bestehende Kontaktfeldstecker 10 weist auf seiner oberen Stirnfläche beispielsweise 4x32 = 128 senkrecht nach oben weisende Kontaktstifte 18 auf, die jeweils einen Durchmesser in der Größenordnung von 0,8 mm haben und beispielsweise 2,5 mm hoch sind. Diese Kontaktstifte 18 des Kontaktfeldsteckers 10 setzen sich im Inneren desselben in Leitungen 20 fort, die jeweils mit einem Anschlußpunkt 22 auf der gedruckten Schaltung der Treiberplatte 12 verbunden sind und somit die elektrische Verbindung mit den elektronischen Komponenten 24 (nur eine ist dargestellt) auf der Treiberplatte 12 herstellt, die Teil der Prüfschaltung des Leiterplattenprüfgerätes sind. Jeder der Kontaktstifte 18 ragt in eine Bohrung 25 eines Federkontaktfeldkörpers 26 hinein, die eine Kontaktfeder 28 aus elektrisch leitendem Werkstoff enthält und diese Bohrung 25 im wesentlichen ausfüllt. In dem gezeichneten bevorzugten Ausführungsbeispiel der Fig. 3 besteht der Federkontaktfeldkörper 26 aus zahlreichen Streifen mit jeweils einer Reihe von Bohrungen darin (entsprechend der Anordnung der Kontaktstifte), doch liegt es auf der Hand, daß es sich nicht um streifenförmige Körper mit nur einer Reihe von Bohrungen 25 handeln muß, sondern es ist ebenso gut möglich, mehrere oder viele Reihen von Bohrungen in einem entsprechend größer gestalteten Federkontaktfeldkörper 26 vorzusehen, da die Größe der Unterteilung dieser Federkontaktfeldkörper an sich nur von der günstigsten Herstellbarkeit solcher Körper abhängig ist: Zur Zeit werden allerdings wegen der genaueren Herstellbarkeit solche Körper als Streifen mit nur einer Reihe von Bohrungen bevorzugt, wobei diese Streifen in Längsrichtung (Fig. 3) oder auch in Querrichtung (nicht dargestellt) auf den Kontaktfeldsteckern 10 angeordnet sein können, d.h. im letztgenannten Fall erstrecken sie sich gerade über die Breite der Kontaktfeldstekker 10. Die Streifen sind etwa 50 mm hoch und 1,27 mm breit. Die Bohrungen darin haben einen Durchmesser von ca. 0.8 mm und der Abstand von Bohrung zu Bohrung beträgt entsprechend dem Rastermaß der Kontaktpunkte 1,27 mm.

Die Federkontaktfeldkörper 26 werden auf den bzw. die nagelbrettartigen Kontaktfeldstecker 10 aufgesteckt. In jede somit von unten von jeweils einem Kontaktstift 18 abgeschlossene Bohrung 25 wird eine besonders ausgebildete Druckfeder 28 eingesetzt, die diese Bohrung vollständig ausfüllt, d.h., die Windungen der Druckfeder liegen im federnden Teil derselben unmittelbar an den Wandungen der Bohrung an. so daß trotz der beengten Platzverhältnisse Druckfedern mit dem größtmöglichen Durchmesser verwendet werden können.

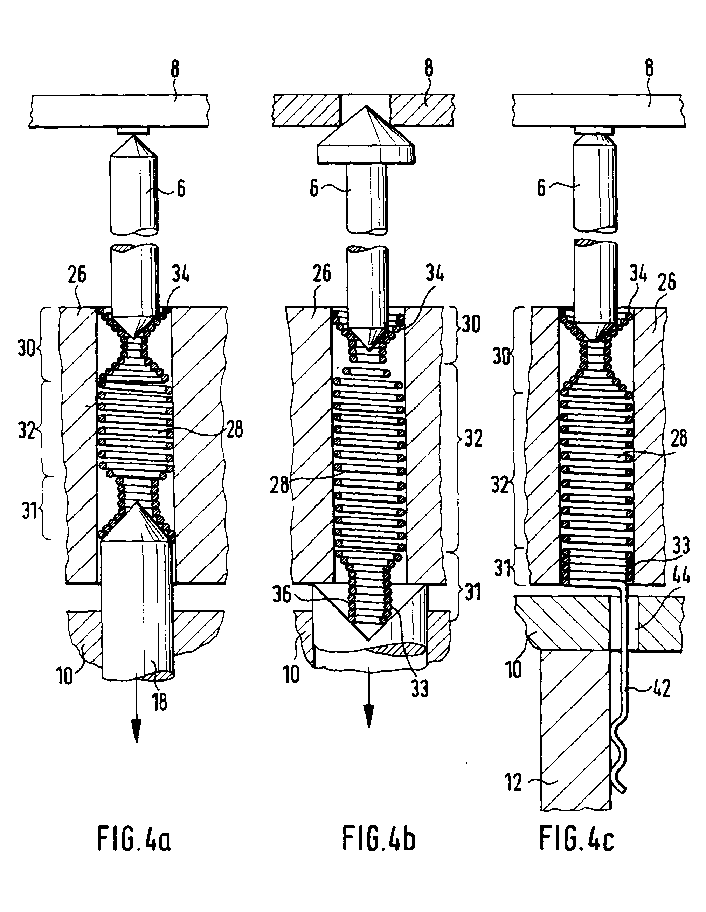

Die stirnseitigen Enden 30, 31 der Druckfedern 28. die in der Fig. 3 nur in prinzipieller Darstellung gezeigt sind, sind in besonderer Weise zur direkten Kontaktierung mit dem Kontaktstift 18 des nagelbrettartigen Kontaktfeldsteckers 10 bzw. dem starren Prüfstift 6 ausgestaltet. Gemäß Fig. 4a ist die Druckfeder 28 an beiden stirnseitigen Enden, d.h. auswärts vom federnden Teil 32, der voneinander beabstandete Windungen aufweist, mit in Längsrichtung aneinanderliegenden Windungen gewikkelt, die zur Ausbildung eines Innenkonusses sich in Wickelrichtung der Feder im Durchmesser verjüngen und anschließend wieder erweitern. Auf diese Weise wird an beiden Stirnseiten dieser Druckfeder ein Innenkonus 34 zur Aufnahme der Spitzen des Kontaktstiftes 18 bzw. des Prüfstiftes 6 ausgebildet. Vorzugsweise können diese aus einem Federstahl gewickelten Druckfedern 28 durch galvanische Abscheidung mit einem geeigneten Kontaktwerkstoff beschichtet sein, wobei die aneinanderliegenden Windungen an den stirnseitigen Enden "zusammenwachsen" können.

Aus Fig. 4b ist eine alternative Kontaktierungsform ersichtlich. Die Druckfeder ist in ihrem oberen Bereich zum Angriff an dem Prüfstift 6 identisch ausgebildet, d.h.. sie weist einen wie zuvor beschrieben gewickelten Innenkonus 34 auf, während das entgegengesetzte Ende mit einem sich stiftartig verjüngenden Ansatz 36 gewickelt ist. dessen einzelne Windungen 33 wiederum aneinanderliegen. Dieser stiftartige Ansatz ragt in eine beispielsweise kegel- oder napfförmige Vertiefung im Kontaktfeldstecker 10 hinein, wobei diese Vertiefung als Alternative zu den zuvor beschriebenen Kontaktstiften 18 anzusehen ist.

In der Fig. 4c ist eine weitere alternative Ausführungsform der Druckfeder gezeigt: Das dem Kontaktfeldstecker bzw. der Treiberplatte zugewandte Ende der Druckfeder 28 ist mit einem sich in Längsrichtung der Druckfeder erstreckenden Kontaktzungenteil 42 versehen, der sich unmittelbar bis zu dem zugehörigen Kontaktpunkt auf der Oberfläche der Treiberplatte 12 erstreckt. Dies bedeutet, daß der Kontakffeldstecker lediglich mit entsprechend positionierten dünnen Bohrungen 44 versehen sein muß, durch die diese Kontaktzungen 42 beim Aufbau des Kontaktfeldes eingeführt werden. Das dem Prüfstift 6 zugewandte Ende der Druckfeder 28 ist auch in diesem Fall so gewickelt, daß ein Innenkonus 34 aus in Längsrichtung aneinanderliegenden Windungen der Druckfeder gebildet wird.

Es liegt auf der Hand, daß die erfindungsgemäße besondere Art der Kontaktierung der in Längsrichtung starren Prüfstifte 6 über als Druckfedern (Spiralfedern) ausgebildete Kontaktpunkte ebenso gut auch bei Leiterplattenprüfgeräten eingesetzt werden kann. die mit einem fest verdrahteten Kontaktpunktraster versehen sind, also keine Kontaktfeldmoduln aufweisen, die untereinander identisch und in Bezug auf die jeweiligen Plätze auf der Grundplatte austauschbar sind. Dennoch ist die vorliegende Erfindung gerade bei diesem letztgenannten Konzept besonders wertvoll, da es ebenso wie die vorliegende Erfindung wesentlich darauf abstellt, die für die Kontaktierung der zu prüfenden Leiterplatte/Verbindungsträger anfallenden Kosten stark zu reduzieren.

### BEZUGSZEICHENLISTE

2 Kontaktteld
4 Kontaktpunkte
6 Prüfstifte
8 Leiterplatte
10 Kontaktfeldstecker (Nagelbrett-)
12 Treiberplatte
14 Tragteile
16 Gestell
18 Kontaktstifte
20 Leitungen
22 Anschlußpunkt
24 elektr. Komponenten
26 Federkontaktfeldkörper
27
28 Kontaktteder/Druckfeder
28 Kontaktfeder/Druckfeder
30 stirnseitige Enden der Druckfeder
31 stirnseitige Enden der Druckfeder
32 federnder Teil der Druckfeder
33 Windungen der Druckfeder
34 Innenkonus
36 stiftartiger Ansatz
38
40
42 Kontaktzungenteil
44 Bohrungen
46
48
50

## Patentansprüche

1. Leiterplattenprüfgerät, mit einer Vielzahl von im Kontaktfeld (2) des Gerätes angeordneten Kontaktpunkten (4), die an eine elektronische Ansteuerungsund Meßvorrichtung angeschlossen und im Leiterplattenprüfgerät gegen den aufzubringenden Kontaktdruck abgestützt sind, wobei die Kontaktpunkte (4) in einem Federkontaktfeldkörper (26) aus elektrisch isolierendem Material angeordnet sind, der aus rasterförmig anreihbaren, zusammenfügbaren Segmenten aufgebaut ist, die je nach den Anforderungen der zu prüfenden Leiterplatte (8) untereinander austauschbar sind,
dadurch gekennzeichnet, daß
- die Kontaktpunkte (4) über in Längsrichtung starre Prüfstifte (6) mit den Kontaktpunkten der zu prüfenden Verbindungsträger/Leiterplatten (8) verbindbar und im Leiterplattenprüfgerät federnd gelagert sind,
- die Kontaktpunkte (4) als elektrisch leitende Druckfedern (28) ausgebildet sind, die in Bohrungen (25) des Federkontaktfeldkörpers (26) unmittelbar anliegend an den Wandungen der Bohrungen (25) angeordnet sind und auf denen die starren Prüfstifte (6) direkt abgestützt sind,
- Segmente voneinander unterschiedlicher, von Null verschiedener Anschlußdichte im Kontaktfeld vorhanden sind.

## Claims

1. Printed circuit board test device having a number of contact points (4) arranged in the contact panel (2) of the device, which are connected to an electronic control and measuring device and which, in the printed circuit test device, are supported against the contact pressure to be applied, the contact points (4) being arranged in a spring contact panel body (26), made from electrically insulating material, that is constructed from matrix-type segments which can be attached and joined together and are interchangeable in accordance with the requirements of the printed circuit board (8) to be tested,
**characterised in that**
- the contact points (4) are connectable with the wiring backplanes/printed circuit boards (8) via test probes (6), which are rigid in the longitudinal direction, said contact points being supported by springs in the printed circuit board test device,
- the contact points (4) are constructed as electrically-conducting compression springs (28) and are arranged in holes (25) of the spring contact panel (26) in direct contact with the walls of the holes (25) and on which the rigid test probes (6) are directly supported,
- segments, which have contact densities differing from each other and from zero, are provided in the contact panel.

## Revendications

1. Dispositif de test électronique pour circuits imprimés présentant plusieurs points de contact (4) agencés dans le champ de contact (2) du dispositif, qui sont connectés à un dispositif de commande et de mesure électronique et sont en appui dans le dispositif de test électronique pour circuits imprimés à l'encontre de la pression de contact à appliquer, les points de contact (4) étant agencés dans un organe de champ de contact à ressorts (26) en matériau électriquement isolant, lequel est constitué de segments susceptibles d'être assemblés et disposés en rangées sous la forme d'une trame, et lesdits segments étant mutuellement interchangeables selon les besoins des circuits imprimés à tester (8),
caractérisé en ce que
- les points de contact (4) peuvent être connectés aux points de contact des circuits imprimés à tester (8) par l'intermédiaire de broches de test (6) rigides suivant la direction longitudinale, et sont montés de façon élastique dans le dispositif de test pour circuits imprimés,
- les points de contact (4) sont réalisés sous forme de ressorts de pression (28) électriquement conducteurs, qui sont agencés dans des trous (25) de l'organe de champ de contact à ressort (26) en s'appuyant directement contre les parois des trous (25), et sur lesquels les broches de test rigides (6) sont directement en appui, et
- il est prévu dans le champ de contact des segments qui présentent des densités de raccordement différentes les unes des autres et différentes de zéro.
